# EUROPEAN PATENT APPLICATION

(11) **EP 4 739 044 A1**
(43) Date of publication of application: **06.05.2026**
(21) Application number: 25210277.7
(22) Date of filing: 22.10.2025
(51) Int. Cl.: H10H 29/01, H10H 29/80, H10H 20/01

(54) **VERTICALLY STACKED RED-GREEN-BLUE FULL-COLOR CHIP-ON-CARRIER FOR MICROLED DISPLAY PANELS AND METHOD OF MANUFACTURING THE SAME**

(30) Priority: 30.10.2024 KR 20240151592; 03.12.2024 KR 20240177192; 03.12.2024 KR 20240177193; 02.09.2025 KR 20250124032
(71) Applicant: Wavelord Co., Ltd, Hwaseong-si, Gyeonggi-do 18589 (KR)
(72) Inventor: SONG, Juneo, 16517 Suwon-si, Gyeonggi-do (KR); MOON, Ji Hyung, 15853 Gunpo-si, Gyeonggi-do (KR); KIM, Tae Kyoung, 18148 Osan-si, Gyeonggi-do (KR); YUN, Hyeong Seon, 10891 Paju-si, Gyeonggi-do (KR)
(74) Representative: Jung, Minkyu

(57) **Abstract**

The present disclosure relates to a vertically stacked red-green-blue full-color chip-on-carrier for a microLED display panel, and the vertically stacked red-green-blue full-color chip-on-carrier for a microLED display panel includes a temporary wafer, and a plurality of light-emitting diode (LED) stacks each including light-emitting portions stacked in a vertical direction through a bonding layer and aligned on the temporary wafer, wherein each of the plurality of LED stacks has a short passage formed in a partial region, such that current flows to the light-emitting portion where the short passage is not formed to emit only a specific color, and the short passage includes a first short passage formed to correspond to a width of the light-emitting portion and a second short passage formed to pass through the light-emitting portion.

According to the present disclosure, since a chip-on-carrier is formed with a plurality of LED stacks in which a plurality of light-emitting portions are vertically stacked on a temporary wafer, and each of the plurality of LED stacks has been already formed with a short passage, a company which receives the chip-on-carrier may easily manufacture a microLED display panel with only a bonding process to a silicon (Si) CMOS or glass TFT backplane wafer without performing a separate epitaxy growth or stacking process. Accordingly, there are effects that a manufacturing process is simplified, the burden on manufacturing equipment and infrastructure is reduced, a process time is shortened, and manufacturing yield is enhanced.

## Description

### CROSS-REFERENCE TO RELATED APPLICATION

This application claims priority to and the benefit of Korean Patent Application No. 10-2024-0151592, filed on 30 October 2024; No. 10-2024-0177192, filed on 3 December 2024, No. 10-2024-0177193, filed on 3 December 2024 and No. 10-2025-0124032, filed on 2 September 2025 the disclosure of which is incorporated herein by reference in its entirety.

### BACKGROUND

### 1. Field of the Invention

The present disclosure relates to a vertically stacked red-green-blue full-color chip-on-carrier for a microLED display panel, and a method of manufacturing the same, and more specifically, to a vertically stacked red-green-blue full-color chip-on-carrier for a microLED display panel in which a color filter is not required by using an engineering monolithic epitaxy wafer method and allowing each of the LED stacks to emit only a specific color, and a method of manufacturing the same.

### 2. Discussion of Related Art

The types of implementation of the metaverse, which has recently been attracting attention, are classified into four types such as virtual reality (VR), augmented reality (AR), mixed reality (MR), and extended reality (XR). It is expected that the metaverse ecosystem will develop in the future, focusing on XR, which is a reality that combines VR, AR, and MR among the four types. In addition, in order to implement this effectively, devices (for example, smart glasses, head-mounted displays, and the like) that include microdisplays with a diagonal length of less than one inch as a core component, along with software for next-generation computing platforms that can deliver innovative user experiences, are required. Particularly, the development of high-performance microdisplay panel technology is absolutely necessary to provide XR users with the greatest immersion, visibility, and convenience and minimize dizziness.

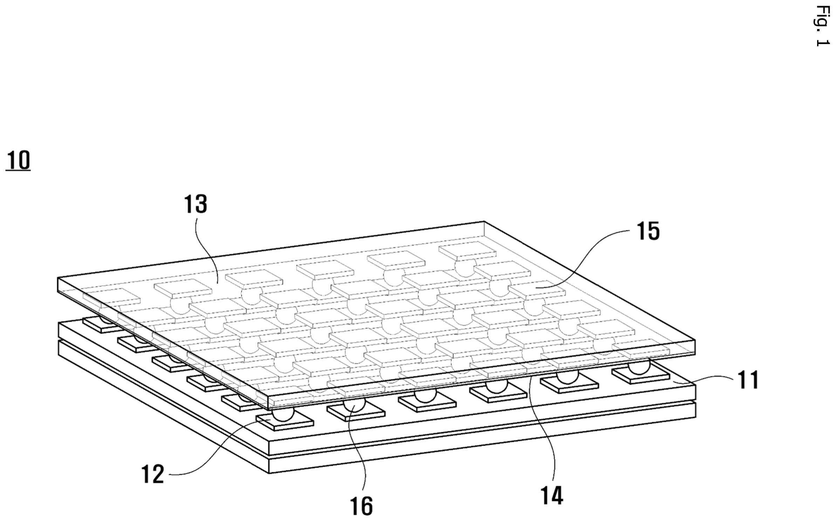

As shown in FIG. 1, a conventional microdisplay panel 10 corresponds to a technology that combines a Si CMOS semiconductor wafer process and a high-resolution, high-brightness, ultra-small display process, and the conventional microdisplay panel 10 may have a structure in which a Si CMOS wafer 11 that has a (100) crystal plane of 4" or more and is provided with a plurality of CMOS electrode pads 12, a plurality of microLED electrode pads 14, and a transparent wafer 13 of 4" or more that is provided with a plurality of microLED chips 15 are bonded through a conductive bond 16. Meanwhile, the types of microdisplay panels expected to be applied to XR devices include liquid crystal (LC)-based LC on Si (LCoS), organic light-emitting diode (OLED)-based OLED on Si (OLEDoS), and LED on Si (LEDoS) based on ultra-small microLEDs with pixel sizes of less than 5 µm. In addition, in the case of VR where displays with a low pixel density are applied, the microdisplay panels are being developed and mass-produced mainly based on LCoS and OLEDoS.

However, with the advancement of metaverse implementation technology, the need for lightweight AR, MR, and XR devices to which microdisplay panels with a high pixel density are applied is gradually increasing. In addition, although the development of LEDoS (a microLED pixel light source composed of red-green-blue subpixels less than 5 µm is adopted) technology, which is considered an ideal solution in theory based on its superior inorganic properties, is urgently needed to satisfy these needs, a microdisplay panel platform for this has not yet been established.

LEDoSs based on ultra-small microLEDs with pixel sizes of less than 5 µm have the advantages of an excellent power-to-performance ratio (P/P) and a short response speed when applied to XR devices, and since the LEDoSs are composed of inorganic materials, there are the advantages that the LEDoSs have a long lifespan, and have efficient power use to reduce heat generation and enable long-term battery life. Particularly, since XR devices have a very short distance between the display and the eyes, even a slight delay in image conversion can easily cause discomfort such as dizziness. Thus, LEDoS, which has a nanosecond response speed, is considered to be the most suitable for XR devices compared to LCoS and OLEDoS, which have a microsecond response speed.

Furthermore, it is evaluated that the biggest reason why LEDoS is attracting attention in AR, MR, and XR devices, unlike VR, is due to its brightness and luminous efficiency. Since smart glasses can be worn regardless of location, high brightness is essential for normal operation even in outdoor environments such as sunlight. In theory, microLEDs support brightness of tens to millions of nits, and since OLEDs are made of organic materials, whereas microLEDs are made of inorganic materials, the microLEDs also have the advantage of high luminous efficiency.

However, despite the above-described advantages, the biggest reason why LEDoSs based on ultra-small microLEDs with pixel sizes of less than 5 µm have not established as a major component of XR devices is the difficulty in mass production. In other words, LEDoS requires millions of ultra-small microLEDs to be fixed on a Si CMOS wafer so that the process difficulty is high and the yield is very low, which leads to increased manufacturing costs and high component prices. This is reflected in the final consumer price, and it is difficult to satisfy market demand as LEDoS is supplied as a high-priced XR device.

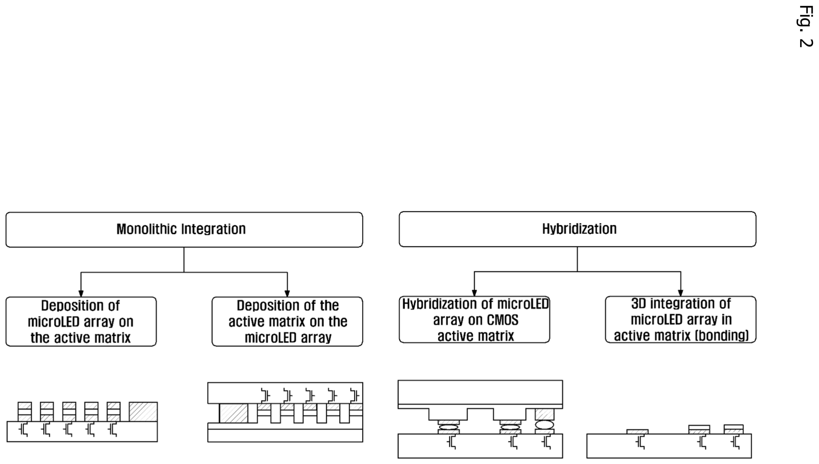

Meanwhile, referring to FIG. 2, the development of LEDoS to which group III-V compound (GaN, GaP, and the like) microLED light sources are applied has been in progress until recently through traditional approaches such as (1) monolithic integration of wafers (or unit dies) composed of microLED arrays on CMOS wafers or (2) hybridization between wafers (or unit dies) on blue, green, and red light source wafers (or unit dies) on which CMOS wafers or microLED arrays are fabricated.

One of the biggest obstacles to the development of LEDoS to which blue, green, and red microLED light sources composed of group III-V compounds to date are applied is the difficulty in securing a solution for pixels of less than 5 µm. In addition, recently, 5 µm-level pixels have been successfully demonstrated using monolithic integration technology, and some demonstrators developed based on hybridization technology were fabricated using sapphire flip chips, achieving 10 µm- level pixels. Additionally, it has been demonstrated that it is possible to reduce pixels to the 5 µm level in the same way by using micro tube wiring in hybridization technology. However, both monolithic integration and hybridization technologies are impractical solutions with significant challenges in mass production in terms of quality and yield, making mass production difficult.

The above-described monolithic integration technology and hybridization technology have a common feature of separately designing and manufacturing a front plane wafer composed of a group III-V compound microLED array and a Si CMOS back plane wafer composed of numerous IC electrode pad arrays, and then assembling the wafers. However, the microLED array manufactured at the unit die level or wafer level on the Si CMOS wafer needs to be ultra-finely aligned regardless of the method. Thus, in this case, alignment is limited to the precision of the process-related device, which has a significant impact on the pixel and inter-pixel distance (pitch) limitations, and mass production also becomes difficult. Accordingly, a new alternative solution that is capable of overcoming the above-described ultra-fine alignment constraints is required to manufacture LEDoS to which high-resolution, high-brightness, and high-speed driving blue, green, and red microLED light sources with pixels of less than 5 µm and pitches of less than 3 µm are applied.

Accordingly, although several impressive demonstrations with 6 µm pixels have been recently released using engineering monolithic epitaxy wafers manufactured through a low-temperature metal bonding process between a Si CMOS wafer and a microLED array wafer, mass production is considered impossible due to low quality and yield issues caused by low-temperature metal bonding and the use of small-diameter wafers of less than 6 inches. Above all, when fabricating ultra-fine pixels of less than 3 µm for microdisplays using conventional engineering monolithic epitaxy wafers using metal bonding, the patterning etching process faces even greater difficulties.

As another example, great progress has been made in solving the problem of limitations in the brightness and resolution of LEDoS to which group III-V compound microLED light sources are recently applied, and a novel engineered monolithic epitaxy wafer approach has been proposed that can provide high-volume, low-cost manufacturing solutions using 12-inch large-diameter Si CMOS wafers.

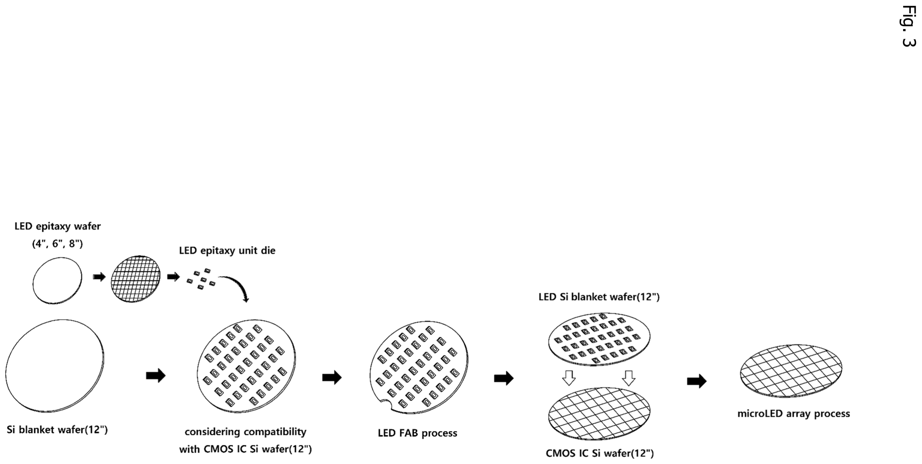

Referring to FIG. 3, the corresponding technology is specifically performed through the following four-step process using an engineering monolithic epitaxy wafer. (1) First, an LED epitaxy cut to a predetermined size (for example, 4 mm × 6 mm) is aligned and bonded at a unit die level on a 12-inch large-diameter Si blanket wafer using an LED epitaxy wafer. Afterward, the growth wafer and buffer layer of the LED epitaxy are removed and then planarized to leave only an LED active layer of a predetermined thickness (for example, approximately 1.5 µm) on the large-diameter Si blanket wafer, and then the LED fab process in the form of a pixel chip is completed. (2) Subsequently, the Si blanket wafer with the completed pixel chip is bonded to a 12-inch CMOS IC Si wafer at the wafer level through multi-layer metal bonding. (3) Subsequently, the Si blanket wafer is removed. (4) Subsequently, the remaining process is finally performed on the CMOS IC Si wafer for the microLED array that functions as a pixel.

However, in step (1), when bonding the LED epitaxy unit die on the Si blanket wafer, there is a limitation that the alignment needs to be performed on a CMOS IC Si wafer of the same size to bond the LED epitaxy unit die on the Si blanket wafer. In addition, in step (2), when bonding with a multi-layer metal including a low-melting-point metal (Sn or In), there is a problem in that a phenomenon of overflowing low-melting-point metal components occurs relatively easily, resulting in a short circuit defect that is electrically connected between the microLED sub-pixel arrays in the panel or with the adjacent CMOS IC electrode pad array. Furthermore, in step (2), there is a problem that defects occur due to the difficulty in ultra-fine alignment wafer bonding between the Si blanket wafer (that is, front plane wafer) and the CMOS IC Si wafer due to the optically opaque nature of the Si blanket wafer and the multi-layer metal bonding layer. Here, the ultra-fine alignment means aligning the microLED array, which is a plurality (hundreds to tens of millions) of ultra-small pixel chips provided on a Si blanket wafer, and the CMOS IC electrode pad array provided on a CMOS IC Si wafer in a 1:1 ratio.

That is, although the engineering monolithic epitaxy wafer approach presented in the above-described technologies is evaluated to provide a solution that brings us one step closer to the implementation of LEDoS based on ultra-small microLEDs with pixel sizes of less than 5 µm, since there are quality and yield issues caused by the use of metals (low temperature, multi-layer) in wafer bonding, and it is very difficult to manufacture high-resolution microdisplays with ultra-fine pixels of less than 3 µm, and there are also problems with some alignment processes, new alternatives are needed.

In addition, since the conventional vertically stacked tandem structure of the microdisplay which adopts conventional microLED pixel light sources still uses a color filter to implement full color, there are disadvantages in terms of color quality, process complexity, and productivity.

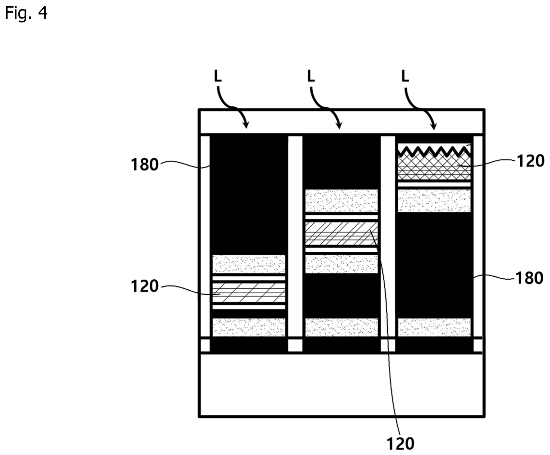

Meanwhile, in the vertically stacked tandem structure, there is a problem that unwanted sub-pixel emission may occur due to optical excitation. Referring to FIG. 4, in order to solve this, a structure in which a short passage 180 is formed after etching the remainder of each LED stack L except for a light-emitting portion 120 which emits a specific color is possible, but in this case, since the light-emitting portion 120 located in an intermediate layer should be etched deeply, difficulty in the etching process increases, and there is also a limitation that a conductive material is not sufficiently charged and thus it is difficult to stably form the short passage 180, so improvement is required.

### [Related Art Document]

### [Patent Document]

(Patent Document 0001) Korea Patent Publication No. 10-2018-0009116

### SUMMARY OF THE INVENTION

The present disclosure is directed to solving the above-described conventional problems and providing a vertically stacked red-green-blue full-color chip-on-carrier for a microLED display panel in which a color filter is not required by using an engineering monolithic epitaxy wafer method and allowing each of the LED stacks to emit only a specific color, and a method of manufacturing the same.

According to the present disclosure, there is provided a vertically stacked red-green-blue full-color chip-on-carrier for a microLED display panel including: a temporary wafer; and a plurality of light-emitting diode (LED) stacks each including light-emitting portions stacked in a vertical direction through a bonding layer and aligned on the temporary wafer, wherein each of the plurality of LED stacks has a short passage in a partial region, such that current flows to the light-emitting portion where the short passage is not formed to emit only a specific color, and the short passage includes a first short passage formed to correspond to a width of the light-emitting portion and a second short passage formed to pass through the light-emitting portion.

Further, the plurality of LED stacks may include a first LED stack including a first light-emitting portion that emits a first color, a second LED stack including a second light-emitting portion that emits a second color, and a third LED stack including a third light-emitting portion that emits a third color.

In addition, the first LED stack may include the first short passage formed in a portion of the third light-emitting portion, and the second short passage formed to pass through the second light-emitting portion, the second LED stack may include the first short passage formed in the portion of the third light-emitting portion, and the first short passage formed in a portion of the first light-emitting portion, and the third LED stack may include the second short passage formed to pass through the second light-emitting portion, and the first short passage formed in the portion of the first light-emitting portion.

In addition, a common electrode may be formed on upper portions or lower portions of the plurality of LED stacks.

In addition, a sacrificial separation layer may be formed on the temporary wafer.

According to the present disclosure, there is provided a method of manufacturing a vertically stacked red-green-blue full-color chip-on-carrier for a microLED display panel including: a preparation step of preparing a plurality of front wafers including a support wafer and light-emitting portions; a stacking step of forming a stack in which the plurality of light-emitting portions are vertically stacked on the support wafer by repeatedly bonding another front wafer onto one front wafer through a bonding layer and then removing the support wafer of the other front wafer; a first processing step of forming a short passage on one surface of the stack; a second processing step of bonding a temporary wafer to one surface of the stack, removing the support wafer, and then forming the short passage on the other surface of the stack; and an etching step of etching the stack and separating the stack into preset units to allow the plurality of LED stacks to be aligned on the temporary wafer, wherein each of the plurality of LED stacks is formed with a short passage in a partial region, such that current flows to the light-emitting portion where the short passage is not formed to emit only a specific color, and the short passage includes a first short passage formed to correspond to a width of the light-emitting portion and a second short passage formed to pass through the light-emitting portion.

Further, the plurality of LED stacks may include a first LED stack including a first light-emitting portion that emits a first color, a second LED stack including a second light-emitting portion that emits a second color, and a third LED stack including a third light-emitting portion that emits a third color.

In addition, the first LED stack may include the first short passage formed in a portion of the third light-emitting portion, and the second short passage formed to pass through the second light-emitting portion, the second LED stack may include the first short passage formed in the portion of the third light-emitting portion, and the first short passage formed in a portion of the first light-emitting portion, and the third LED stack may include the second short passage formed to pass through the second light-emitting portion, and the first short passage formed in the portion of the first light-emitting portion.

In addition, a common electrode may be formed on upper portions or lower portions of the plurality of LED stacks.

In addition, a sacrificial separation layer may be formed on the temporary wafer.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 shows a structure of a conventional microdisplay panel;
FIG. 2 shows a conventional light-emitting diode on silicon (LEDoS) development approach;
FIG. 3 shows an approach using a conventional engineering monolithic epitaxy wafer;
FIG. 4 shows an example of a microdisplay panel structure provided with a short passage;
FIG. 5 is a flowchart of a method of manufacturing a vertically stacked red-green-blue full-color chip-on-carrier for a microLED display panel according to one embodiment of the present disclosure;
FIGS. 6 to 9 show a process of preparing a front wafer in the method of manufacturing a vertically stacked red-green-blue full-color chip-on-carrier for a microLED display panel according to one embodiment of the present disclosure;
FIGS. 10 and 11 show a process of forming a stack by stacking light-emitting portions according to the method of manufacturing a vertically stacked red-green-blue full-color chip-on-carrier for a microLED display panel according to one embodiment of the present disclosure;
FIGS. 12 and 13 show a process of manufacturing a vertically stacked red-green-blue full-color chip-on-carrier for a microLED display panel according to the method of manufacturing a vertically stacked red-green-blue full-color chip-on-carrier for a microLED display panel according to one embodiment of the present disclosure;
FIG. 14 shows a vertically stacked red-green-blue full-color chip-on-carrier for a microLED display panel according to one embodiment of the present disclosure;
FIG. 15 shows a common electrode formed on upper portions of a plurality of LED stacks of the vertically stacked red-green-blue full-color chip-on-carrier for a microLED display panel according to one embodiment of the present disclosure; and
FIG. 16 shows a common electrode formed on lower portions of the plurality of LED stacks of the vertically stacked red-green-blue full-color chip-on-carrier for a microLED display panel according to one embodiment of the present disclosure.

### DETAILED DESCRIPTION OF EXEMPLARY EMBODIMENTS

Hereinafter, some embodiments of the present disclosure will be described in detail through exemplary drawings. When assigning reference numerals to components of each of the drawings, it should be noted that identical components are denoted by the same reference numerals as much as possible even when they are shown on different drawings.

In addition, when describing embodiments of the present disclosure, when a detailed description of a related known configuration or function is determined to hinder understanding of the embodiment of the present disclosure, the detailed description is omitted.

In addition, when describing components of embodiments of the present disclosure, terms such as first, second, A, B, (a), (b), and the like may be used. These terms are only intended to distinguish the components from other components, and the nature, order, or sequence of the components are not limited by the terms. These terms are only for the purpose of distinguishing one component from another component, and the nature, sequence, order, or the like of the corresponding components is not limited by these terms.

Hereinafter, a method S100 of manufacturing a vertically stacked red-green-blue full-color chip-on-carrier for a microLED display panel according to one embodiment of the present disclosure will be described in detail with reference to the accompanying drawings.

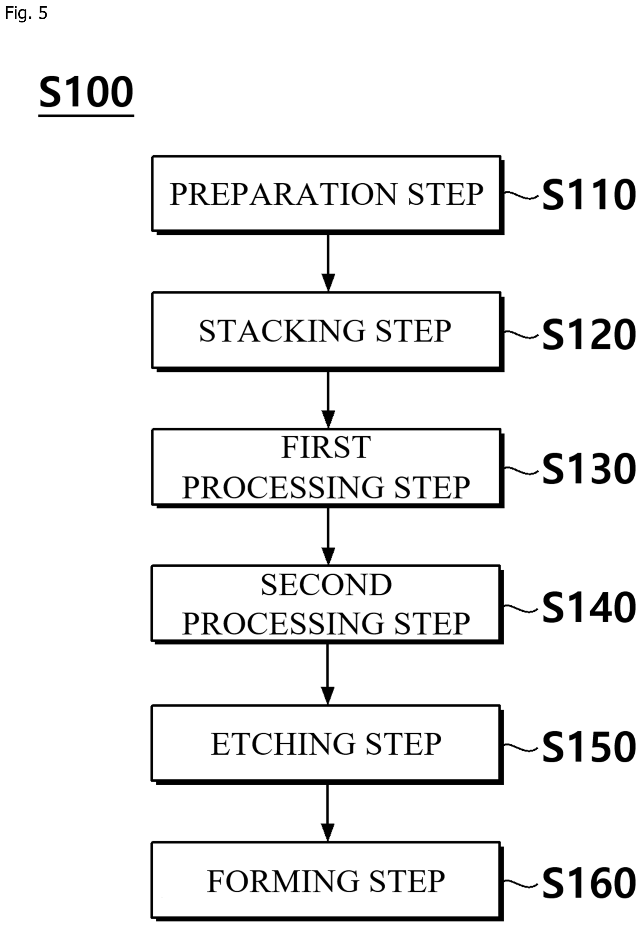

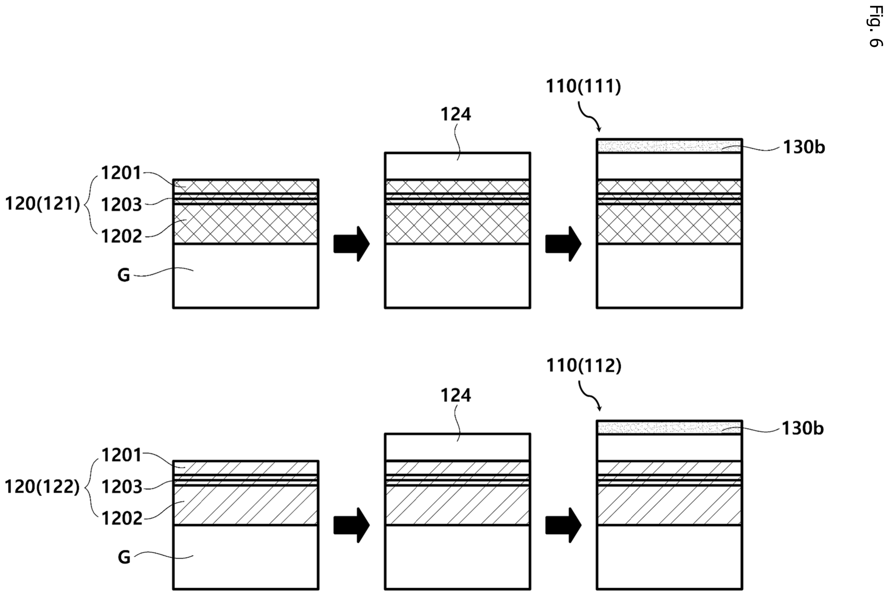

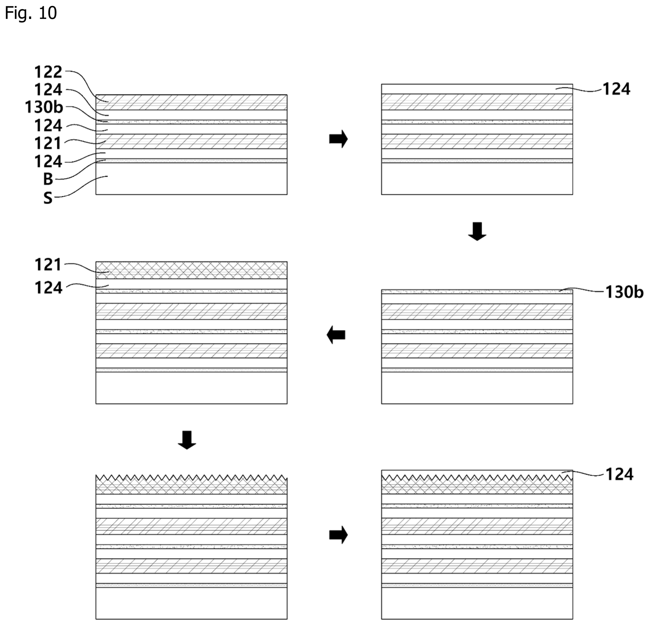

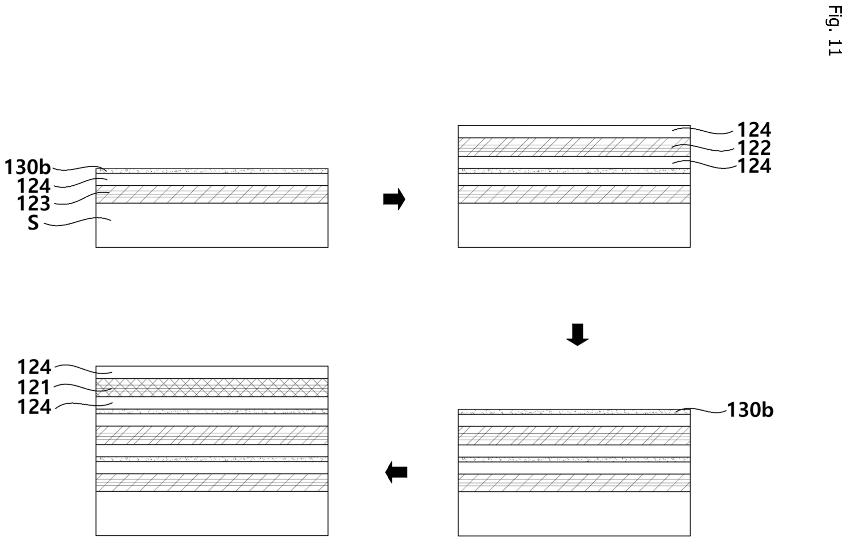

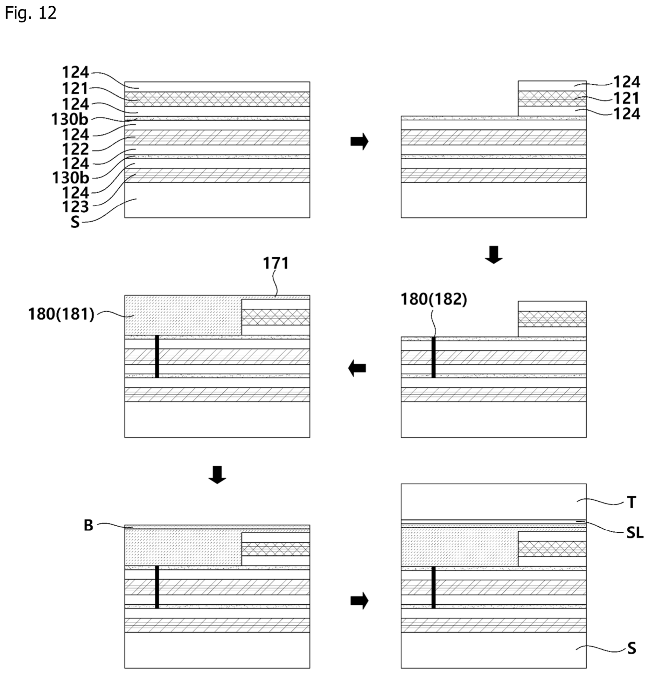

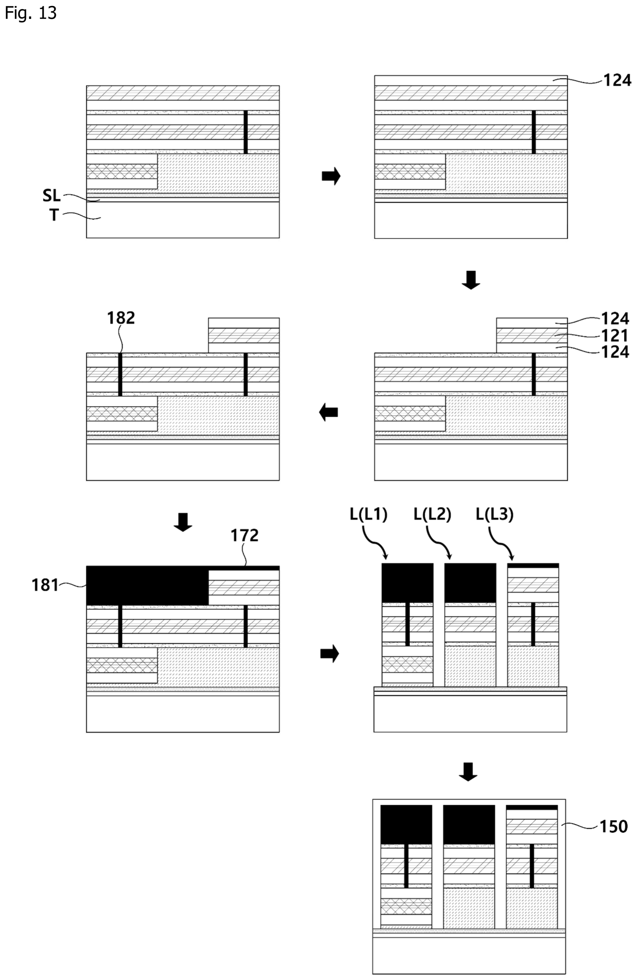

FIG. 5 is a flowchart of the method of manufacturing a vertically stacked red-green-blue full-color chip-on-carrier for a microLED display panel according to one embodiment of the present disclosure, FIGS. 6 to 9 show a process of preparing a front wafer in the method of manufacturing a vertically stacked red-green-blue full-color chip-on-carrier for a microLED display panel according to one embodiment of the present disclosure, FIGS. 10 and 11 show a process of forming a stack by stacking light-emitting portions according to the method of manufacturing a vertically stacked red-green-blue full-color chip-on-carrier for a microLED display panel according to one embodiment of the present disclosure, and FIGS. 12 and 13 show a process of manufacturing a vertically stacked red-green-blue full-color chip-on-carrier for a microLED display panel according to the method of manufacturing a vertically stacked red-green-blue full-color chip-on-carrier for a microLED display panel according to one embodiment of the present disclosure.

Referring to FIG. 5, the method S100 of manufacturing a vertically stacked red-green-blue full-color chip-on-carrier for a microLED display panel according to one embodiment of the present disclosure includes a preparation step S110, a stacking step S120, a first processing step S130, a second processing step S140, an etching step S150, and a forming step S160.

The preparation step S110 is a step of preparing a plurality of front wafers 110 and 210.

The plurality of front wafers 110 and 210 are each provided to emit different colors, and the plurality of front wafers 110 and 210 may include first front wafers 111 and 211 for emitting a first color, second front wafers 112 and 212 for emitting a second color different from the first color, and third front wafers 113 and 213 for emitting a third color different from the first and second colors. Meanwhile, the first color, the second color, and the third color may be, for example, red, green, and blue, respectively, but are not limited thereto, and may include various other colors.

Here, the first front wafers 111 and 211 include a support wafer S and a first light-emitting portion 121 disposed on an upper portion of the support wafer S, the second front wafers 112 and 212 include the support wafer S and a second light-emitting portion 122 disposed on the upper portion of the support wafer S, and the third front wafers 113 and 213 include the support wafer S and a third light-emitting portion 123 disposed on the upper portion of the support wafer S.

The light-emitting portion 120 is provided to generate light and may emit blue light, green light, or red light. In the present disclosure, when the light-emitting portion 120 emits blue light or green light, binary, ternary, or quaternary compounds such as InN, InGaN, GaN, AlGaN, AIN, AlGaInN, and the like which are group III (Al, Ga, and In) nitride semiconductors among group III-V compound semiconductors, may be disposed in an appropriate position and order on an initial growth wafer G and epitaxially grown.

Particularly, in order to emit blue or green light, a high-quality group III nitride semiconductor such as InGaN with a high In composition should be preferentially formed on an upper portion of a group III nitride semiconductor composed of GaN, AlGaN, AIN, or AlGaInN, but is not limited thereto.

Further, in the present disclosure, when the light-emitting portion 120 emits red light, binary, ternary, and quaternary compounds such as InP, InGaP, GaP, AlInP, AlGaP, AIP, AlGaInP, and the like which are group III (Al, Ga, and In) phosphide semiconductors among group III-V compound semiconductors may be disposed in an appropriate position and order on the initial growth wafer G and epitaxially grown. In addition, in recent years, in order to further improve the development of equipment and process technology and the value of display panel products, in the case of emitting red light, a high-quality group III nitride semiconductor such as InGaN with a high In composition of 30% or more, other than the group III phosphide semiconductor may be preferentially formed on an upper portion of a group III nitride semiconductor composed of GaN, AlGaN, AIN, or AlGaInN.

Particularly, in order to emit red light, a high-quality group III phosphide semiconductor such as InGaP having a high In composition should be preferentially formed on an upper portion of a group III phosphide semiconductor composed of GaP, AlInP, AlGaP, AIP, or AlGaInP, but is not limited thereto, and hereinafter, the description will be based on the group III nitride semiconductor.

More specifically, each of the light-emitting portions 120 may include a first semiconductor region 1201 (for example, a p-type semiconductor region), an active region 1203 (for example, multi quantum wells, MQWs), and a second semiconductor region 1202 (for example, an n-type semiconductor region), have a structure in which the second semiconductor region 1202, the active region 1203, and the first semiconductor region 1201 are sequentially epitaxially grown on the growth wafer G, and ultimately have an overall thickness of about 5.0 to 8.0 µm typically, including a plurality of multi-layer group III nitrides, but is not limited thereto.

Each of the first semiconductor region 1201, the active region 1203, and the second semiconductor region 1202 may be formed as a single layer or multiple layers, and although not shown, before epitaxially growing the light-emitting portion 120 on an upper portion of the growth wafer G, required layers such as a buffer layer may be added to improve the quality of the epitaxially grown light-emitting portion 120. For example, the buffer layer may be configured with a thickness of typically about 4.0 µm, including a compliant layer CL composed of an undoped semiconductor region and a nucleation layer NL to relieve stress and improve thin film quality. Further, when the growth wafer G is removed using a laser lift off (LLO) technique, a sacrificial layer may be provided between the nucleation layer and the undoped semiconductor region, and a seed layer may also function as the sacrificial layer.

The second semiconductor region 1202 is provided to have a second conductivity and is formed on the growth wafer G. The second semiconductor region 1202 may have a thickness of 2.0 to 3.5 µm.

The active region 1203 is provided to generate light using the recombination of electrons and holes and is formed on the second semiconductor region 1202. The active region 1203 may have a thickness of several tens of nm in multiple layers.

The first semiconductor region 1201 is provided to have a first conductivity (p-type) and is formed on the active region 1203. The first semiconductor region 1201 may have a thickness of several tens of nm to several µm in multiple layers, and a surface thereof may have gallium polarity (Ga-polarity).

That is, since the active region 1203 is interposed between the first semiconductor region 1201 and the second semiconductor region 1202, when holes in the first semiconductor region 1201 which is a p-type semiconductor region, and electrons in the second semiconductor region 1202 which is an n-type semiconductor region recombine in the active region 1203, light may be generated.

Further, in the process of preparing the front wafer 110, an optically transparent and electrically conductive ohmic contact electrode 124 that is electrically connected to the light-emitting portion 120 by making ohmic contact therewith may be formed on at least one of upper and lower surfaces of the light-emitting portion 120, which will be described below.

The support wafer S is provided to support the light-emitting portion 120 (the first light-emitting portion 121, the second light-emitting portion 122, or the third light-emitting portion 123) disposed on an upper portion, and when the initial growth wafer G is not removed, the growth wafer G may be the support wafer S, and may be a separate wafer bonded to remove the initial growth wafer G.

Hereinafter, a process of manufacturing the front wafer 110 used to stack the light-emitting portions 120 of the vertically stacked red-green-blue full-color chip-on-carrier 100 of the present disclosure in an n-side up structure will be described.

Referring to FIG. 6, a process of manufacturing the first front wafer 111 is as follows

In the case of the first front wafer 111 for emitting red light, a front wafer 110 in a p-side up form is prepared by sequentially epitaxially growing a second semiconductor region 1202, an active region 1203, and a first semiconductor region 1201 on a GaAs growth wafer G, forming a p-type ohmic contact electrode 124 having transparent conductivity on an upper surface of the first semiconductor region 1201, and then depositing and forming a second bonding layer 130b having transparent conductivity on the ohmic contact electrode 124. In this case, the growth wafer G may serve as the support wafer S, and the first front wafer 111 may have a structure in which the support wafer S, the light-emitting portion 120, the ohmic contact electrode 124, and the second bonding layer 130b are sequentially stacked.

Further, referring to FIG. 6, a process of manufacturing the second front wafer 112 in the embodiment is as follows.

In the case of the second front wafer 112 for emitting green light, a front wafer 110 in a p-side up form is prepared by sequentially epitaxially growing a second semiconductor region 1202, an active region 1203, and a first semiconductor region 1201 on a sapphire (a-phase Al₂O₃) growth wafer G, forming a p-type ohmic contact electrode 124 having transparent conductivity on an upper surface of the first semiconductor region 1201, and then depositing and forming a second bonding layer 130b having transparent conductivity on the ohmic contact electrode 124. In this case, the growth wafer G may serve as the support wafer S, and the second front wafer 112 may have a structure in which the support wafer S, the light-emitting portion 120, the ohmic contact electrode 124, and the second bonding layer 130b are sequentially stacked.

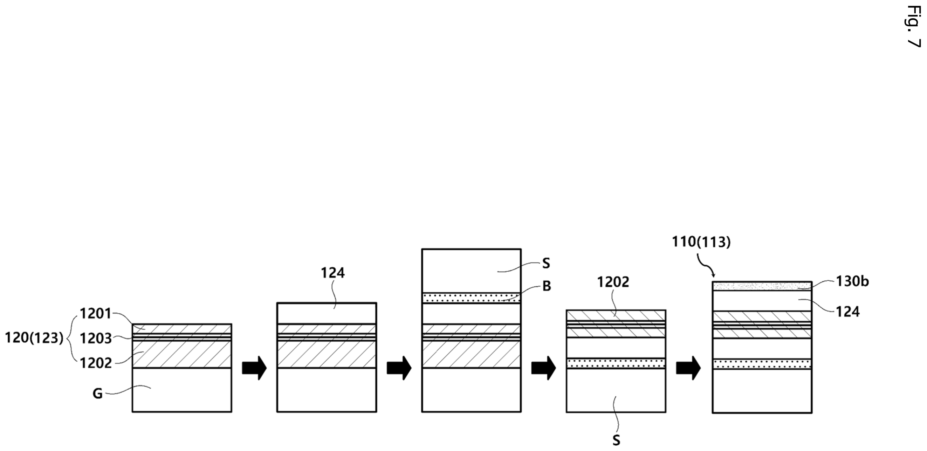

Further, referring to FIG. 7, the process of manufacturing the third front wafer 113 in the embodiment is as follows.

In the case of the third front wafer 113 for emitting blue light, after sequentially epitaxially growing a second semiconductor region 1202, an active region 1203, and a first semiconductor region 1201 on a sapphire (a-phase Al₂O₃) growth wafer G, a p-type ohmic contact electrode 124 having transparent conductivity is formed on an upper surface of the first semiconductor region 1201, and then a support wafer S and the ohmic contact electrode 124 are bonded through a bonding layer B. Thereafter, the growth wafer G is separated from the light-emitting portion 120 using a laser lift off (LLO) technique, the second semiconductor region 1202 is etched to reduce the thickness of the second semiconductor region 1202, an n-type ohmic contact electrode 124 having transparent conductivity is formed on the surface of the second semiconductor region 1202 whose thickness is reduced, and a second bonding layer 130b is deposited and formed on the n-type ohmic contact electrode 124, thereby preparing a front wafer 110 in an n-side up form. In this case, the support wafer S may be formed of a Si material having a (111), (110) or (100) crystal plane in addition to an optically transparent material such as sapphire or glass, but is not limited thereto, and the third front wafer 113 may have a structure in which the support wafer S, the bonding layer B, the ohmic contact electrode 124, the light-emitting portion 120, the ohmic contact electrode 124, and the second bonding layer 130b are sequentially stacked.

Meanwhile, hereinafter, the process of manufacturing the front wafer 210 used to stack the light-emitting portion 120 of the vertically stacked microdisplay panel 100 of the present disclosure in a p-side up structure will be described.

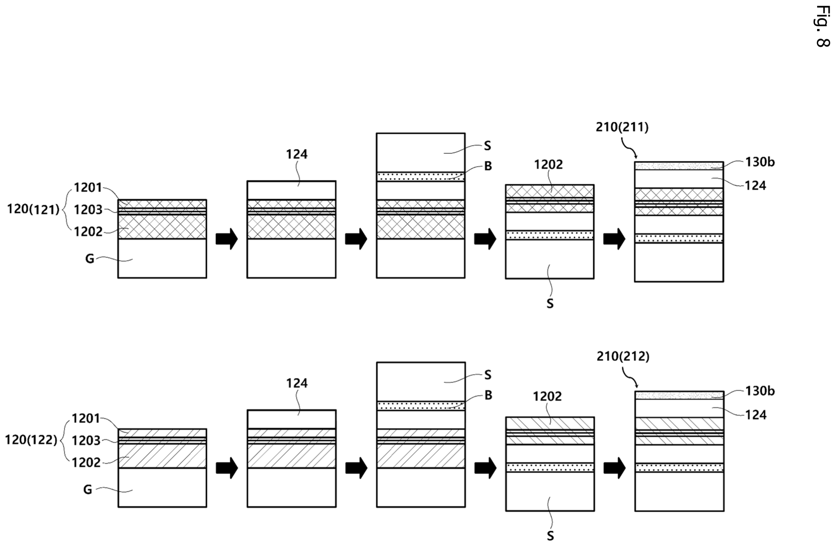

Referring to FIG. 8, a process of manufacturing the first front wafer 211 in the embodiment is as follows.

In the case of the first front wafer 211 for emitting red light, after sequentially epitaxially growing a second semiconductor region 1202, an active region 1203, and a first semiconductor region 1201 on a GaAs growth wafer G, a p-type ohmic contact electrode 124 having transparent conductivity is formed on an upper surface of the first semiconductor region 1201, and then a support wafer S and the ohmic contact electrode 124 are bonded through a bonding layer B. Thereafter, the growth wafer G may is separated from the light-emitting portion 120 using a chemical lift off (CLO) technique, the second semiconductor region 1202 is etched to reduce the thickness of the second semiconductor region 1202, an n-type ohmic contact electrode 124 having transparent conductivity is formed on the surface of the second semiconductor region 1202 whose thickness is reduced, and a second bonding layer 130b is deposited and formed on the n-type ohmic contact electrode 124, thereby preparing a front wafer 210 in an n-side up form. In this case, the support wafer S may be formed of a Si material having a (111), (110) or (100) crystal plane in addition to the optically transparent material such as sapphire or glass, but is not limited thereto, and the first front wafer 211 may have a structure in which the support wafer S, the bonding layer B, the ohmic contact electrode 124, the light-emitting portion 120, the ohmic contact electrode 124, and the second bonding layer 130b are sequentially stacked.

Further, referring to FIG. 8, a process of manufacturing the second front wafer 212 in the embodiment is as follows.

In the case of the second front wafer 212 for emitting green light, after sequentially epitaxially growing a second semiconductor region 1202, an active region 1203, and a first semiconductor region 1201 on a sapphire (a-phase Al₂O₃) growth wafer G, a p-type ohmic contact electrode 124 having transparent conductivity is formed on an upper surface of the first semiconductor region 1201, and then a support wafer S and the ohmic contact electrode 124 are bonded through a bonding layer B. Thereafter, the growth wafer G is separated from the light-emitting portion 120 using a laser lift off (LLO) technique, the second semiconductor region 1202 is etched to reduce the thickness of the second semiconductor region 1202, an n-type ohmic contact electrode 124 having transparent conductivity is formed on the surface of the second semiconductor region 1202 whose thickness is reduced, and a second bonding layer 130b is deposited and formed on the n-type ohmic contact electrode 124, thereby preparing a front wafer 210 in an n-side up form. In this case, the support wafer S may be formed of a Si material having a (111), (110) or (100) crystal plane in addition to the optically transparent material such as sapphire or glass, but is not limited thereto, and the second front wafer 212 may have a structure in which the support wafer S, the bonding layer B, the ohmic contact electrode 124, the light-emitting portion 120, the ohmic contact electrode 124, and the second bonding layer 130b are sequentially stacked.

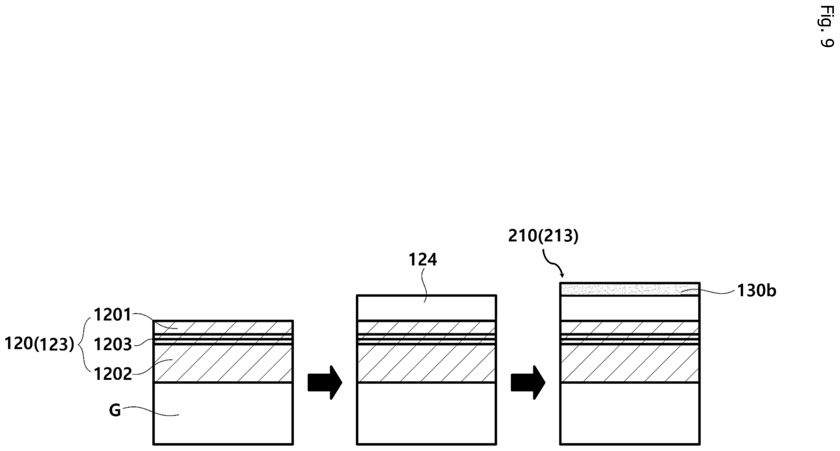

Further, referring to FIG. 9, the process of manufacturing the third front wafer 213 in the embodiment is as follows.

In the case of the third front wafer 213 for emitting blue light, after a second semiconductor region 1202, an active region 1203, and a first semiconductor region 1201 are sequentially epitaxially on a sapphire (a-phase Al₂O₃) growth wafer G which is an optically transparent and high-temperature resistant wafer in which a laser beam (single wavelength light) is 100% transmitted (in theory) without absorption, a p-type ohmic contact electrode 124 having transparent conductivity is formed on an upper surface of the first semiconductor region 1201, and then a second bonding layer 130b is deposited and formed on the ohmic contact electrode 124, thereby preparing a front wafer 210 in a p-side up form. In this case, the growth wafer G may serve as the support wafer S, and may have a structure in which the support wafer S, the light-emitting portion 120, the ohmic contact electrode 124, and the second bonding layer 130b are sequentially stacked in addition to the optically transparent material such as sapphire or glass.

Meanwhile, in the case of green light and blue light, a blue or green light-emitting portion 120 may be formed on a Si growth wafer G having a (111) crystal plane instead of a sapphire (a-phase Al₂O₃) growth wafer G, and in this case, the Si growth wafer G may be separated and removed by a mechanical polishing technique or a chemical etching technique (chemical lift off, CLO).

Furthermore, in the present disclosure, the materials of the growth wafer G, the support wafer S and/or the temporary wafer T may each be silicon (Si) or sapphire, but the selection of the materials may be determined depending on a wafer bonding method.

For example, when bonding at room temperature through a surface activation process (surface activated bonding), wafers of different materials such as silicon (Si) or sapphire may be selected regardless of the thermal expansion coefficient, but when bonding at a temperature of 50°C or higher between wafers such as the growth wafer G, the support wafer S, and the temporary wafer T, or when annealing at a temperature of 50°C or higher without removing one side wafer in a state where bonding between the wafers has been performed, wafers of the same material should be selected.

Meanwhile, in the above-described process of manufacturing the front wafers 110 and 210, before the ohmic contact electrode 124 is formed on the surface of the first semiconductor region 1201 or the surface of the second semiconductor region 1202, when the surface of the first semiconductor region 1201 is exposed (in a p-side up form) or the surface of the second semiconductor region 1202 is exposed (in an n-side up form), the surfaces may be polished and smoothly planarized through mechanical polishing (MP) or chemical-mechanical polishing (CMP), respectively, so as to have a smooth surface.

Further, the ohmic contact electrodes 124 of the front wafers 110 and 210 are formed of a material having transparent conductivity, and when the ohmic contact electrode 124 is formed to be in contact with the first semiconductor region 1201 which is a p-type semiconductor, the material of the ohmic contact electrode 124 may include NiO, PtO, PdO, AgO₂, Au, Rh₂O₃, RuO₂, In₂O₃, SnO₂, ZnO, IZO, ITO, IGZO, and the like and when the ohmic contact electrode 124 is formed to be in contact with the second semiconductor region 1202 which is an n-type semiconductor, the material of the ohmic contact electrode 124 may include TiN, CrN, VN, In₂O₃, SnO₂, ZnO, IZO, ITO, IGZO, and the like. Furthermore, since the surface of the second semiconductor region 1202 having nitrogen polarity (N-polarity) has a much higher surface roughness than the surface of the first semiconductor region 1201 having gallium polarity (Ga-polarity), it is preferable to introduce a chemical-mechanical polishing (CMP) process of polishing and planarizing the surface of the second semiconductor region 1202 before forming the ohmic contact electrode 124 having transparent conductivity.

Further, the surface of the ohmic contact electrode 124 formed on the front wafers 110 and 120 may also be polished and smoothly planarized through mechanical polishing (MP) or chemical-mechanical polishing (CMP).

The stacking step S120 is a step of forming a stack in which the plurality of light-emitting portions 120 are vertically stacked on the support wafer S by repeatedly bonding another front wafer 110 onto one front wafer 110 through the second bonding layer 130b and then removing the support wafer S of the other front wafer 110.

Here, the second bonding layer 130b may be formed of a transparent insulating material (for example, SiO₂ or SiNₓ) which is optically transparent and has an electrically insulating property, or may be formed of a transparent conductive material (for example, ITO, IZO, or ZnO) which is optically transparent and having electrical conductivity, and it is preferable that second bonding layer 130b is formed of a transparent insulating material to secure bonding strength.

Here, optically transparent means transparent (a transmittance of 80% or more) or translucent (semitransparent with a transmittance of 50% or more) in the wavelength range of light (including visible light) used in an optical exposure (photolithography) process, and electrically conductive means having an electrical resistance of less than 10⁻³ Ω/cm.

When the second bonding layer 130b is formed of a transparent insulating material, the transparent insulating material may be prepared with, for example, an oxide such as SiO₂, Al₂O₃, HfO₂, ZrO₂, Ta₂O₅, or the like or a nitride such as Si₃N₄, AIN, or the like, but is not limited thereto.

Further, when the second bonding layer 130b is formed of a transparent conductive material, the transparent conductive material may be formed of a ceramic material. For example, the transparent conductive material may be formed of a transparent conductive oxide (TCO), a transparent conductive nitride (TCN), a transparent conductive oxide nitride (TCON), or the like. In this case, when the ceramic material is a transparent conductive oxide, the ceramic material may include In₂O₃, SnO₂, ZnO, IZO, ITO, IGZO, and the like, when the ceramic material is a transparent conductive nitride, the ceramic material may include TiN, CrN, and VN, and when the ceramic material is a transparent conductive oxide nitride, the ceramic material may include InON, SnON, ZnON, IZON, ITON, IGZON, and the like, but the present disclosure is not limited thereto.

Meanwhile, the second bonding layer 130b may also be formed of an opaque conductive metal material (for example: Au, Ag, Cu, Sn, In, or Zn).

Hereinafter, a process of stacking the light-emitting portions 120 of the vertically stacked red-green-blue full-color chip-on carrier 100 of the present disclosure in an n-side up structure will be described with reference to FIG. 10.

Specifically, in the stacking step S120, for example, the second front wafer 112 in a p-side up form which emits green light is bonded onto the third front wafer 113 in an n-side up form which emits blue light through the second bonding layer 130b, and then the support wafer S of the second front wafer 112 is removed using laser lift-off or the like. Thereafter, the second semiconductor region 1202 of the second light-emitting portion 122 exposed by removing the support wafer S is etched to reduce a thickness thereof, and then the n-type ohmic contact electrode 124 is formed on the surface of the second semiconductor region 1202, and the second bonding layer 130b is deposited on the n-type ohmic contact electrode 124.

Next, the first front wafer 111 in a p-side up form which emits red light is bonded through the second bonding layer 130b, and then the support wafer S of the first front wafer 111 is removed using chemical lift-off or the like. Thereafter, the second semiconductor region 1202 of the first light-emitting portion 121 exposed by removing the support wafer S is etched to reduce a thickness thereof, and then the n-type ohmic contact electrode 124 is formed on the surface of the second semiconductor region 1202. In this case, when the second semiconductor region 1202 of the first light-emitting portion 121 is etched, a surface texturing process may be performed on the surface of the second semiconductor region 1202.

Accordingly, since the support wafer S, the bonding layer B, the third light-emitting portion 123 having an ohmic contact electrode 124 formed on each of the upper and lower surfaces, the second bonding layer 130b, the second light-emitting portion 122 having an ohmic contact electrode 124 formed on each of the upper and lower surfaces, the second bonding layer 130b, and the first light-emitting portion 121 having an ohmic contact electrode 124 formed on each of the upper and lower surfaces are stacked in the vertical direction to form a stack on the support wafer S.

Meanwhile, the stacking step S120 may use the property of smooth surfaces sticking to each other due to a van der Waals force without using high pressure or an external electric field. Accordingly, it is preferable to introduce the chemical-mechanical polishing (CMP) process before bonding the front wafers 110 to each other so that the roughness of each bonding surface is very low (Rq, < 0.5 nm @ 2 µm × 2 µm) and there are no particles such as impurities between the surfaces. To this end, in the stacking step S120, before bonding the front wafers 110 to each other, the surface of the second bonding layer 130b of the front wafers 110 may be polished and smoothly planarized through mechanical polishing (MP) or chemical-mechanical polishing (CMP), respectively.

Meanwhile, in the present disclosure, after the stack is formed by stacking all RGB light-emitting portions 120, annealing should be performed at a high-temperature of 200 to 900°C to enhance the bonding strength of the second bonding layer 130b, and thus strong bonding strength between the RGB light-emitting portions 120 may be secured

In this case, since there is a risk that the short passage 180 may be damaged when high-temperature annealing is performed to strengthen the bonding strength between the RGB light-emitting portions 120 after the first processing step S130, and there is a risk that a CMOS electrode panel or the like may be damaged when annealing is performed to strengthen the bonding strength between the RGB light-emitting portions 120 after the vertically stacked red-green-blue full-color chip-on-carrier 100 of the present disclosure is supplied and bonded to a silicon (Si) CMOS backplane wafer or the like, it is preferable to perform the annealing in the stacking step S120.

Hereinafter, a process of stacking the light-emitting portions 120 of the vertically stacked red-green-blue full-color chip-on carrier 100 of the present disclosure in a p-side up structure will be described with reference to FIG. 11.

Specifically, in the stacking step S120, first, the second front wafer 212 in an n-side up form which emits green light is bonded to the third front wafer 213 in a p-side up form which emits blue light through the second bonding layer 130b, and then the support wafer S of the second front wafer 212 is removed using laser lift-off or the like and the second bonding layer 130b is deposited on the p-type ohmic contact electrode 124.

Thereafter, the first front wafer 211 in a p-side up form which emits red light is bonded through the second bonding layer 130b, and then the support wafer S of the first front wafer 211 is removed using chemical lift-off or the like so that the p-type ohmic contact electrode 124 is exposed to the outside.

Accordingly, since the support wafer S, the bonding layer B, the third light-emitting portion 123 having an ohmic contact electrode 124 formed on each of the upper and lower surfaces, the second bonding layer 130b, the second light-emitting portion 122 having an ohmic contact electrode 124 formed on each of the upper and lower surfaces, the second bonding layer 130b, and the first light-emitting portion 121 having an ohmic contact electrode 124 formed on each of the upper and lower surfaces are stacked in the vertical direction to form a stack on the support wafer S.

Meanwhile, as described above, after the stack is formed by stacking all RGB light-emitting portions 120, annealing should be performed at a high-temperature of 200 to 900°C to enhance the bonding strength of the second bonding layer 130b, and thus strong bonding strength between the RGB light-emitting portions 120 may be secured.

The first processing step S130 is a process of forming a short passage 180 on one surface of the stack.

Referring to FIGS. 12 and 13, specifically, in the first processing step S130, first, portions of the first light-emitting portion 121 where a third LED stack L3 and a second LED stack L2 are to be formed are etched and removed along with the ohmic contact electrodes 124 on upper portions and lower portions of the first light-emitting portion 121, and are etched and removed until the second bonding layer 130b is exposed.

Thereafter, a through hole is formed in the portion where the third LED stack L3 is to be formed to pass through the second light-emitting portion 122, and then a conductive material is filled in the through hole to form a second short passage 182.

In this case, the through hole may be formed to pass through the active region 1203 of the second light-emitting portion 122, and particularly, when the second bonding layer 130b is formed of a transparent insulating material, it is preferable that the through hole is formed to pass through both the second bonding layer 130b between the first light-emitting portion 121 and the second light-emitting portion 122 and the second bonding layer 130b between the second light-emitting portion 122 and the third light-emitting portion 123 until the surface of the ohmic contact electrode 124 of the third light-emitting portion 123 is exposed.

Thereafter, in the first processing step S130, a conductive material is filled in the etched portion to form a first short passage 181.

In this case, after forming the first short passage 181, the corresponding material may remain on the ohmic contact electrode 124 of the unetched first light-emitting portion 121 or may also be removed, and when the corresponding material is left on the ohmic contact electrode 124 of the first light-emitting portion 121, a transmissive layer 171 is formed, and it is also possible to fill the conductive material in the etched portion and then form the transmissive layer 171 with a different material.

Further, the short passage 180 and the transmissive layer 171 formed on one surface of the stack are formed of a transparent conductive material so that light may be transmitted to the outside.

When the short passage 180 and the transmissive layer 171 are formed of a transparent conductive material, it is preferable that the short passage 180 and the transmissive layer 171 are formed of a material having low resistance and high transmittance. The materials may include In₂O₃, SnO₂, ZnO, IZO, ITO, IGZO, and the like, but are not limited thereto.

Meanwhile, the short passage 180 may be formed in the etched and removed portion or the through hole by filling a conductive material in a direct self-align method, or by filling the conductive material in a liquid coating method such as sol-gel or the like, but is not limited thereto, and any method that can form the short passage 180 may be used.

Meanwhile, when the formation of a common electrode 160 on lower portions of the plurality of LED stacks L is required, the common electrode 160 may be formed on an upper surface of the transmissive layer 171 in the first processing step S130. Here, when the light-emitting portions 120 are in an n-side up form, the common electrode 160 may be formed as a negative electrode, and when the light-emitting portions 120 are in a p-side up form, the common electrode 160 may be formed as a positive electrode.

Here, the common electrode 160 may be formed of a transparent conductive material similar to that of the ohmic contact electrode 124, and when the common electrode 160 is a negative electrode, the material of the common electrode 160 may include TiN, CrN, VN, In₂O₃, SnO₂, ZnO, IZO, ITO, IGZO, and the like, and when the common electrode 160 is a positive electrode, the material of the common electrode 160 may include NiO, PtO, PdO, AgO₂, Au, Rh₂O₃, RuO₂, In₂O₃, SnO₂, ZnO, IZO, ITO, IGZO and the like.

The second processing step S140 is a step of adhering the temporary wafer T to one surface of the stack, removing the support wafer S, and then forming the short passage 180 on the other surface of the stack.

Specifically, in the second processing step S140, the temporary wafer T is bonded to one surface of the stack, that is, the transmissive layer 171, through the bonding layer B, and then the lower support wafer S is separated and the bonding layer B is removed using laser lift-off, chemical lift-off, or the like.

In this case, when the stack is stacked in an n-side up form, the ohmic contact electrode 124 is provided on the upper and lower surfaces of the third light-emitting portion 123, but when the stack is stacked in a p-side up form, since an n-type ohmic contact electrode 124 is not formed on the third light-emitting portion 123, the n-type ohmic contact electrode 124 is additionally formed on the exposed third light-emitting portion 123.

Meanwhile, it is preferable that the temporary wafer T is formed of an optically transparent substrate, such as sapphire or glass, that is easily separated by a laser lift off (LLO) technique, and a sacrificial separation layer SL that is sacrificed and separated when the temporary wafer T is removed using a laser lift off (LLO) technique may be formed on the temporary wafer T.

A material of the sacrificial separation layer SL may include an oxide or a nitride which can be deposited by PVD & CVD techniques such as sputtering, pulsed laser deposition (PLD), an evaporator, MBE, MOCVD, ALD, or the like, and specifically, may include a material such as ITO, GaOₓ, GaON, GaN, InGaN, ZnO, InGaZnO, InZnO, InGaO, or the like, but is not limited thereto.

Thereafter, in the second processing step S140, first, portions of the third light-emitting portion 123 where the first and second LED stacks L1 and L2 are to be formed are etched and removed along with the ohmic contact electrodes 124 on upper portions and lower portions of the third light-emitting portion 123, and are etched and removed until the second bonding layer 130b is exposed. Next, a through hole is formed in the portion where the first LED stack L1 is to be formed to pass through the second light-emitting portion 122, and then a conductive material is filled in the through hole to form the second short passage 182.

In this case, the through hole may be formed to pass through the active region 1203 of the second light-emitting portion 122, and particularly, when the second bonding layer 130b is formed of a transparent insulating material, it is preferable that the through hole is formed to pass through both the second bonding layer 130b between the third light-emitting portion 123 and the second light-emitting portion 122 and the second bonding layer 130b between the second light-emitting portion 122 and the first light-emitting portion 121 until the surface of the ohmic contact electrode 124 of the first light-emitting portion 121 is exposed.

Thereafter, in the second processing step S140, the conductive material is filled in the etched portion to form the first short passage 181.

In this case, after forming the first short passage 181, the corresponding material may remain on the ohmic contact electrode 124 of the unetched third light-emitting portion 123 or may also be removed, and when the corresponding material is left on the ohmic contact electrode 124 of the third light-emitting portion 123, a residual layer 172 is formed, and it is also possible to fill the conductive material in the etched portion and then form the residual layer 172 with a different material.

Further, each of the short passage 180 and the residual layer 172 formed on the other surface of the stack may be formed of a transparent conductive material or an opaque conductive material having reflectivity.

When the short passage 180 and the residual layer 172 are formed of a transparent conductive material, it is preferable that the short passage 180 and the residual layer 172 are formed of a material having low resistance and high transmittance. These materials may include In₂O₃, SnO₂, ZnO, IZO, ITO, IGZO, and the like, but are not limited thereto.

On the other hand, when the short passage 180 and the residual layer 172 are formed of a transparent reflective material, it is preferable that the short passage 180 and the residual layer 172 are formed of a material having low resistance and high reflectivity. These materials may be prepared from Ag, Al, Rh, or the like having high reflectivity in various wavelength ranges, and may also be prepared from Cu, Au, or the like having high reflectivity in specific wavelength ranges. Further, in order to improve the adhesion of highly reflective materials, a stacked structure in which thin adhesion-improving materials such as Ti, Ni, Cr, and Pt are formed to a thickness of several nm or less is also possible, and furthermore, the stacked structure may be prepared using alloys such as AgCu, AgNi, and the like, but is not limited thereto.

The etching step S150 is a step in which a plurality of stacked light-emitting portions 120, the ohmic contact electrodes 124, and the second bonding layers 130b are etched to separate the plurality of light-emitting portions 120, the ohmic contact electrodes 124, and the second bonding layers 130 into preset units, and thus a plurality of LED stacks L are aligned on the temporary wafer T and the first short passage 181 is formed to correspond to a width of the light-emitting portion 120 through the etching step S150.

Meanwhile, the plurality of LED stacks L include a first LED stack L1 for emitting only a first color, a second LED stack L2 for emitting only a second color, and a third LED stack L3 for emitting only a third color.

After the above-described etching step S150 has been performed, the first LED stack L1 may include the first short passage 181 formed in a portion of the third light-emitting portion 123 after the portion of the third light-emitting portion 123 is removed, the second short passage 182 formed to pass through the second light-emitting portion 122, and the first light-emitting portion 121, and current may flow to only the first light-emitting portion 121 through the short passage 180 to emit only a first color, and when a transmissive layer 171 is formed on the first light-emitting portion 121, the transmissive layer 171 may transmit the first color generated in the first light-emitting portion 121.

Further, the second LED stack L2 may include the first short passage 181 formed in a portion of the third light-emitting portion 123 after the portion of the third light-emitting portion 123 is removed, the second light-emitting portion 122, and the first short passage 181 formed in a portion of the first light-emitting portion 121 after the portion of the first light-emitting portion 121 is removed, and current may flow to only the second light-emitting portion 122 through the short passage 180 to emit only a second color.

In addition, the third LED stack L3 may include the third light-emitting portion 123, the second short passage 182 formed to pass through the second light-emitting portion 122, and the first short passage 181 formed in a portion of the first light-emitting portion 121 after the portion of the first light-emitting portion 121 is removed, and current may flow to only the third light-emitting portion 123 through the short passage 180 to emit only a third color, and a residual layer 172 may be formed under the third light-emitting portion 123.

In addition, the first light-emitting portion 121 of the first LED stack L1 may be located above the second light-emitting portion 122 of the second LED stack L2, the second light-emitting portion 122 of the second LED stack L2 may be located above the third light-emitting portion 123 of the third LED stack L3.

The forming step S160 is a step of forming a mold portion 150 which fills a space between the plurality of aligned LED stacks L and serves as a passivation layer. Here, a material of the mold portion 150 may include SiO₂, SiNₓ, Al₂O₃, SOG, BCB, an organic material, or the like. but is not limited thereto.

Meanwhile, when the formation of a common electrode 160 on upper portions of the plurality of LED stacks L is required, the common electrode 160 may be formed on an upper surface of the residual layer 172 in the forming step S160. Here, when the light-emitting portions 120 are in an n-side up form, the common electrode 160 may be formed as a negative electrode, and when the light-emitting portions 120 are in a p-side up form, the common electrode 160 may be formed as a positive electrode. Further, the common electrode 160 may be formed of a transparent conductive material similar to that of the ohmic contact electrode 124. When the common electrode 160 is a negative electrode, the material of the common electrode 160 may include TiN, CrN, VN, In₂O₃, SnO₂, ZnO, IZO, ITO, IGZO, and the like, and when the common electrode 160 is a positive electrode, the material of the common electrode 160 may include NiO, PtO, PdO, AgO₂, Au, Rh₂O₃, RuO₂, In₂O₃, SnO₂, ZnO, IZO, ITO, IGZO, and the like.

Hereinafter, the vertically stacked red-green-blue full-color chip-on-carrier 100 for a microLED display panel according to one embodiment of the present disclosure will be described in detail with reference to the accompanying drawings.

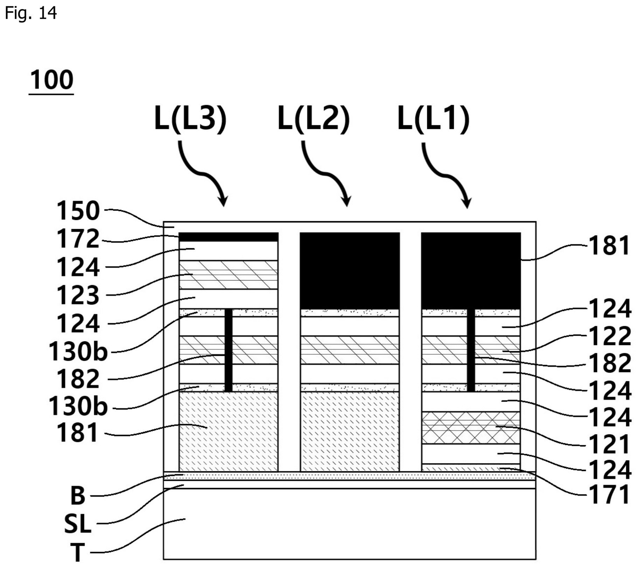

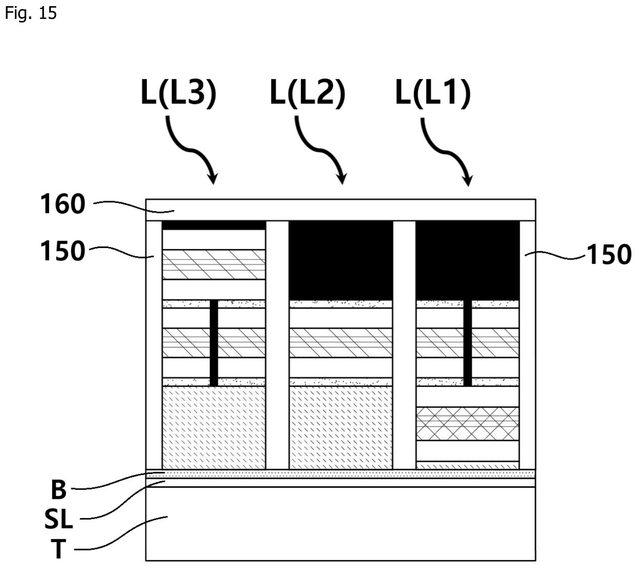

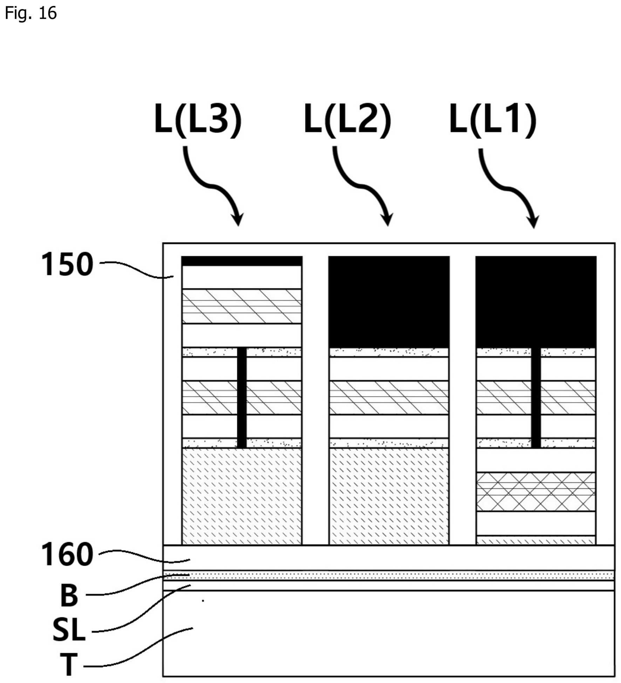

FIG. 14 shows a vertically stacked red-green-blue full-color chip-on-carrier for a microLED display panel according to one embodiment of the present disclosure, FIG. 15 shows a common electrode formed on the upper portions of the plurality of LED stacks of the vertically stacked red-green-blue full-color chip-on-carrier for a microLED display panel according to one embodiment of the present disclosure, and FIG. 16 shows a common electrode formed on lower portions of the plurality of LED stacks of the vertically stacked red-green-blue full-color chip-on-carrier for a microLED display panel according to one embodiment of the present disclosure.

As shown in FIG. 14, the vertically stacked red-green-blue full-color chip-on-carrier 100 for a microLED display panel according to one embodiment of the present disclosure includes a temporary wafer T, a plurality of LED stacks L, and a mold portion 150.

Hereinafter, some descriptions overlapping the method S100 of manufacturing a vertically stacked red-green-blue full-color chip-on-carrier for a microLED display panel according to one embodiment of the present disclosure will be omitted.

The temporary wafer T is bonded to an upper portion of the stack through a bonding layer B, and the materials of the temporary wafer T may be silicon (Si) or sapphire, but the selection of the materials may be determined depending on the wafer bonding method.

Meanwhile, it is preferable that the temporary wafer T is formed of an optically transparent substrate, such as sapphire or glass, that is easily separated by a laser lift off (LLO) technique, and a sacrificial separation layer SL that is sacrificed and separated when the temporary wafer T is removed using a laser lift off (LLO) technique may be formed on the temporary wafer T.

The material of the sacrificial separation layer SL may include an oxide or a nitride which can be deposited by PVD & CVD techniques such as sputtering, pulsed laser deposition (PLD), an evaporator, MBE, MOCVD, ALD, or the like, and specifically, may include a material such as ITO, GaOₓ, GaON, GaN, InGaN, ZnO, InGaZnO, InZnO, InGaO, or the like, but is not limited thereto.

The plurality of LED stacks L are aligned on the temporary wafer T by vertically stacking the plurality of light-emitting portions 120 in an n-side up form or p-side up form through a second bonding layer 130b, and the plurality of LED stacks L include a first LED stack L1 for emitting only a first color, a second LED stack L2 for emitting only a second color, and a third LED stack L3 for emitting only a third color.

The first LED stack L1 may include a first short passage 181 formed with a width corresponding to a portion of the third light-emitting portion 123 after the portion of the third light-emitting portion 123 is removed, a second short passage 182 formed to pass through the second light-emitting portion 122, and the first light-emitting portion 121, and a current may flow to only the first light-emitting portion 121 through the short passage 180 to emit only a first color, and when a transmissive layer 171 is formed on the first light-emitting portion 121, the transmissive layer 171 may transmit the first color generated in the first light-emitting portion 121.

Further, the second LED stack L2 may include the first short passage 181 formed with a width corresponding to a portion of the third light-emitting portion 123 after the portion of the third light-emitting portion 123 is removed, the second light-emitting portion 122, and the first short passage 181 formed with a width corresponding to a portion of the first light-emitting portion 121 after the portion of the first light-emitting portion 121 is removed, and current may flow to only the second light-emitting portion 122 through the short passage 180 to emit only a second color.

In addition, the third LED stack L3 may include the third light-emitting portion 123, the second short passage 182 formed to pass through the second light-emitting portion 122, and the first short passage 181 formed with a width corresponding to a portion of the first light-emitting portion 121 after the portion of the first light-emitting portion 121 is removed, and current may flow to only the third light-emitting portion 123 through the short passage 180 to emit only a third color, and a residual layer 172 may be formed under the third light-emitting portion 123.

In addition, the first light-emitting portion 121 of the first LED stack L1 may be located above the second light-emitting portion 122 of the second LED stack L2, and the second light-emitting portion 122 of the second LED stack L2 may be located above the third light-emitting portion 123 of the third LED stack L3.

Furthermore, as shown in FIG. 15, the common electrode 160 may be formed on the upper portions of the plurality of LED stacks L, and as shown in FIG. 16, the common electrode 160 may also be formed on lower portions of the plurality of LED stacks L.

Here, when the light-emitting portions 120 are in an n-side up form, the common electrode 160 may be formed as a negative electrode, and when the light-emitting portions 120 are in a p-side up form, the common electrode 160 may be formed as a positive electrode. Further, the common electrode 160 may be formed of a transparent conductive material similar to that of the ohmic contact electrode 124, and when the common electrode 160 is a negative electrode, the material of the common electrode 160 may include TiN, CrN, VN, In₂O₃, SnO₂, ZnO, IZO, ITO, IGZO, and the like, and when the common electrode 160 is a positive electrode, the material of the common electrode 160 may include NiO, PtO, PdO, AgO₂, Au, Rh₂O₃, RuO₂, In₂O₃, SnO₂, ZnO, IZO, ITO, IGZO, and the like.

The mold portion 150 is provided to serve as a passivation layer by filling the space between the plurality of aligned LED stacks L, and the material of the mold portion 150 may include SiO₂, SiNₓ, Al₂O₃, SOG, BCB, the organic material, or the like, but is not limited thereto.

According to the above-described vertically stacked red-green-blue full-color chip-on-carrier 100 of the present disclosure, a microLED display panel may be easily manufactured by only bonding the vertically stacked red-green-blue full-color chip-on-carrier 100 to a silicon (Si) CMOS or glass TFT backplane wafer or the like.

Specifically, as the manufactured vertically stacked red-green-blue full-color chip-on-carrier 100 is bonded to the backplane wafer through a first bonding layer, and then the temporary wafer T is removed by a technique such as laser lift-off or the like and the residual sacrificial separation layer SL and bonding layer B are subsequently removed, a microLED display panel may be more easily manufactured.

According to the present disclosure, since a chip-on-carrier is formed with a plurality of LED stacks in which a plurality of light-emitting portions are vertically stacked on a temporary wafer, and each of the plurality of LED stacks has been already formed with a short passage, a company which receives the chip-on-carrier can easily manufacture a microLED display panel with only a bonding process to a silicon (Si) CMOS or glass TFT backplane wafer without performing a separate epitaxy growth or stacking process. Accordingly, there are effects that a manufacturing process is simplified, the burden on manufacturing equipment and infrastructure is reduced, a process time is shortened, and manufacturing yield is enhanced.

Further, according to the present disclosure, there is an effect that formation of a short passage in a vertically stacked tandem structure is easy.

In addition, according to the present disclosure, since a color filter is not required despite the adoption of a vertically stacked tandem structure, the color quality of a microLED display can be significantly enhanced, and process complexity and productivity can be significantly improved.

Further, according to the present disclosure, when designing and manufacturing a microdisplay panel which adopts a microLED pixel light source, unlike the conventional monolithic integration method or hybridization method in which alignment issues are present, since an engineering monolithic epitaxy wafer in which a plurality of LED light-emitting portions are stacked through a bonding process for red, green, and blue LED epitaxy wafers is first manufactured, and then a stack on the engineering monolithic epitaxy wafer is etched to separate the stack into preset units to allow a plurality of LED stacks to be aligned on a plurality of CMOS electrode pads, there is an effect that not only a small-diameter wafer of 6 inches or less but also a large-diameter wafer of 8 inches or more can be used and thus product yield can be significantly increased.

In addition, according to the present disclosure, since a transparent ceramic material (regardless of electrical conductivity) is used in both a bonding layer and an ohmic contact electrode, there is the effect that a problem that an etching byproduct is redeposited does not occur while etching is easy in a plasma dry process for LED stack alignment. Furthermore, the above-described ease of etching provides significant advantages in manufacturing high-resolution microLED display panels with ultra-fine pixels less than 10 µm x 10 µm.

Further, according to the present disclosure, since an LED stack is formed by stacking red, green, and blue LED light-emitting portions on a temporary wafer to form a stack and then etching the stack in pixel units, there is an effect that alignment errors between the red, green, and blue LED light-emitting portions do not occur.

In addition, according to the present disclosure, since red light is not absorbed by other light-emitting portions, the luminous efficiency of red light in a vertically stacked tandem structure can be significantly enhanced.

In addition, since some of other light-emitting portions are removed except for the light-emitting portion which emits the corresponding color in each LED stack of the present disclosure, the occurrence of unwanted sub-pixel emission caused by light excitation due to short-wavelength blue light can be reduced.

In addition, since each LED stack of the present disclosure has a vertical chip structure which can be easily implemented with the chip size of sub-micrometers or less rather than a horizontal and flip chip structure manufactured through a MESA etching process, cost innovation of a panel for a microLED display can be achieved through reduction of pixel light source material costs.

Meanwhile, the effects of the present disclosure are not limited to the above-described effects, and various other effects can be included within a scope apparent to those skilled in the art from the description below.

While all of the components comprising embodiments of the present disclosure have been described above as combining or operating in combination, the present disclosure is not necessarily limited to these embodiments. In other words, any of the components may optionally operate in combination with one or more other components within the scope of the present disclosure.

In addition, terms such as "includes," "consists of," or "has" as used herein shall, unless specifically indicated to the contrary, be construed to mean that the component may be inherent in, and therefore may further include, other components, rather than exclude, other components. All terms, including technical or scientific terms, unless otherwise defined, shall have the same meaning as commonly understood by one of ordinary skill in the art to which this invention belongs. Commonly used terms, such as dictionary-defined terms, are to be interpreted consistent with their contextual meaning in the relevant art and are not to be construed in an idealized or overly formal sense unless expressly defined in the present disclosure.

The above description is merely an exemplary description of the technical spirit of the present disclosure, and those skilled in the art to which the present disclosure pertains will be able to modify and change the present disclosure in various ways without departing from the essential characteristics of the present disclosure.

Therefore, the embodiments disclosed in the present disclosure are not intended to limit the technical spirit of the present disclosure, but intended to describe the same, and the scope of the technical spirit of the present disclosure is not limited by these embodiments. The scope of the present disclosure should be construed according to the appended claims, and all technical spirits within the equivalent range should be construed as being included in the scope of the present disclosure.

## Claims

1. A vertically stacked red-green-blue full-color chip-on-carrier for a microLED display panel, comprising:
a temporary wafer; and
a plurality of light-emitting diode (LED) stacks each including light-emitting portions stacked in a vertical direction through a bonding layer and aligned on the temporary wafer,
wherein each of the plurality of LED stacks has a short passage formed in a partial region, such that current flows to the light-emitting portion where the short passage is not formed to emit only a specific color, and
the short passage includes a first short passage formed to correspond to a width of the light-emitting portion and a second short passage formed to pass through the light-emitting portion.

2. The vertically stacked red-green-blue full-color chip-on-carrier of claim 1, wherein the plurality of LED stacks include a first LED stack including a first light-emitting portion that emits a first color, a second LED stack including a second light-emitting portion that emits a second color, and a third LED stack including a third light-emitting portion that emits a third color.

3. The vertically stacked red-green-blue full-color chip-on-carrier of claim 2, wherein the first LED stack includes the first short passage formed in a portion of the third light-emitting portion, and the second short passage formed to pass through the second light-emitting portion,
the second LED stack includes the first short passage formed in the portion of the third light-emitting portion, and the first short passage formed in a portion of the first light-emitting portion, and
the third LED stack includes the second short passage formed to pass through the second light-emitting portion, and the first short passage formed in the portion of the first light-emitting portion.

4. The vertically stacked red-green-blue full-color chip-on-carrier of any one of claims 1 to 3, wherein a common electrode is formed on upper portions or lower portions of the plurality of LED stacks.

5. The vertically stacked red-green-blue full-color chip-on-carrier of any one of claims 1 to 4, wherein a sacrificial separation layer is formed on the temporary wafer.

6. A method of manufacturing a vertically stacked red-green-blue full-color chip-on-carrier for a microLED display panel, comprising:
a preparation step of preparing a plurality of front wafers including a support wafer and light-emitting portions;
a stacking step of forming a stack in which the plurality of light-emitting portions are vertically stacked on the support wafer by repeatedly bonding another front wafer onto one front wafer through a bonding layer and then removing the support wafer of the other front wafer;
a first processing step of forming a short passage on one surface of the stack;
a second processing step of bonding a temporary wafer to one surface of the stack, removing the support wafer, and then forming the short passage on the other surface of the stack; and
an etching step of etching the stack and separating the stack into preset units to allow the plurality of LED stacks to be aligned on the temporary wafer,
wherein each of the plurality of LED stacks is formed with a short passage in a partial region, such that current flows to the light-emitting portion where the short passage is not formed to emit only a specific color, and
the short passage includes a first short passage formed to correspond to a width of the light-emitting portion and a second short passage formed to pass through the light-emitting portion.

7. The method of claim 6, wherein the plurality of LED stacks include a first LED stack including a first light-emitting portion that emits a first color, a second LED stack including a second light-emitting portion that emits a second color, and a third LED stack including a third light-emitting portion that emits a third color.

8. The method of claim 7, wherein the first LED stack includes the first short passage formed in a portion of the third light-emitting portion, and the second short passage formed to pass through the second light-emitting portion,
the second LED stack includes the first short passage formed in the portion of the third light-emitting portion, and the first short passage formed in a portion of the first light-emitting portion, and
the third LED stack includes the second short passage formed to pass through the second light-emitting portion, and the first short passage formed in the portion of the first light-emitting portion.

9. The method of any one of claims 6 to 8, wherein a common electrode is formed on upper portions or lower portions of the plurality of LED stacks.

10. The method of any one of claims 6 to 9, wherein a sacrificial separation layer is formed on the temporary wafer.
